# FASCICULE DE BREVET EUROPEEN

(11) **EP 3 141 519 B1**
(45) Date de publication et mention de la délivrance du brevet: **14.03.2018**
(21) Numéro de dépôt: 15184184.8
(22) Date de dépôt: 08.09.2015
(51) Int. Cl.: B81B 3/00, G04D 3/00, G04B 15/14

(54) **PROCÉDÉ DE FABRICATION D'UNE PIÈCE MICROMÉCANIQUE HORLOGÈRE**
HERSTELLUNGSVERFAHREN FÜR EIN MIKROMECHANISCHES UHRENBAUTEIL
METHOD FOR MANUFACTURING A MICROMECHANICAL TIMEPIECE PART

(43) Date de publication de la demande: 15.03.2017
(73) Titulaire: Nivarox-FAR S.A., 2400 Le Locle (CH)
(72) Inventeur: Dubois, Philippe, 2074 Marin (CH)
(74) Mandataire: Honoré, Anne-Claire

(56) Documents cités:
- WO-A1-2007/000271
- WO-A1-2012/152843
- DE-B3-102013 113 380

## Description

### Domaine de l'invention

La présente invention se rapporte à un procédé pour produire des pièces micromécaniques horlogères renforcées, à base de silicium. L'invention se rapporte également à une pièce micromécanique horlogère renforcée, à base de silicium, pouvant notamment être obtenue par un tel procédé.

### Arrière-plan de l'invention

Le silicium est un matériau de plus en plus utilisé dans la fabrication de pièces micromécaniques horlogères, notamment des pièces qui restent liées à un substrat à base de silicium sur lequel elles ont été usinées.

Par rapport aux métaux ou alliages classiquement utilisés pour fabriquer des pièces micromécaniques horlogères, telles que des roues dentées, ou les composants de l'échappement, le silicium présente de nombreux avantages. C'est un matériau très dur, d'un poids très léger qui lui permet donc de présenter une inertie très réduite et en conséquence d'améliorer le rendement. Le silicium permet également de réaliser des pièces complexes, ou monobloc.

Afin d'améliorer ou modifier les propriétés du silicium, il est connu de déposer sur le silicium une couche d'un matériau approprié. Ainsi, pour améliorer ses propriétés tribologiques, on dépose sur le silicium du diamant, par exemple par un procédé de dépôts de couche mince en phase vapeur (CVD/PVD). La demande de brevet WO 2012/152843 A1 décrit un ressort spiral en silicium qui comprend une surface oxydée non planaire. Le spiral peut être oxydé rapidement grâce à la présence de sa surface supérieure qui forme un nombre de trous, traversants ou borgnes, et de préférence de forme oblongue. Toutefois, ces procédés présentent un taux de dépôt qui peut s'avérer trop lent lorsque l'épaisseur de la couche déposée dépasse quelques microns. En effet, les taux de dépôts dans les machines CVD par exemple étant typiquement de l'ordre de la dizaine de nanomètre/minute, cette technique n'est généralement pas utilisée pour la fabrication de couche supérieure à quelques microns.

Il est donc nécessaire de proposer un procédé de fabrication d'une pièce micromécanique horlogère à base de silicium permettant de réaliser des dépôts rapides de couches épaisses d'un matériau approprié sur le silicium.

### Résumé de l'invention

A cet effet, la présente invention concerne un procédé de fabrication d'une pièce micromécanique horlogère à partir d'un substrat à base de silicium, comprenant, dans l'ordre, les étapes de :
a) former des pores à la surface d'au moins une partie d'une surface dudit substrat à base de silicium d'une profondeur déterminée,
b) remplir entièrement lesdits pores d'un matériau choisi parmi le diamant, le carbone-diamant (DLC), l'oxyde de silicium, le nitrure de silicium, des céramiques, des polymères et leurs mélanges, afin de former dans les pores une couche dudit matériau d'une épaisseur au moins égale à la profondeur des pores.

La présente invention concerne également une pièce micromécanique horlogère susceptible d'être obtenue par le procédé tel que défini ci-dessus.

Le procédé selon l'invention permet, grâce à la formation préalable de pores à la surface du substrat, de créer une surface réelle de substrat très supérieure à la surface initiale, et en conséquence d'accroitre fortement le taux de dépôt apparent d'un matériau approprié. Ainsi, le procédé selon l'invention permet de fabriquer, en surface du substrat à base de silicium, une couche épaisse d'un matériau approprié en un temps rapide, fortement réduit par rapport à un dépôt sur la surface plane d'un substrat similaire, mais non poreux.

### Brève description des dessins

Les buts, avantages et caractéristiques de la présente invention apparaîtront plus clairement dans la description détaillée suivante d'au moins une forme de réalisation de l'invention donnée uniquement à titre d'exemple non limitatif et illustrée par les dessins annexés sur lesquels :

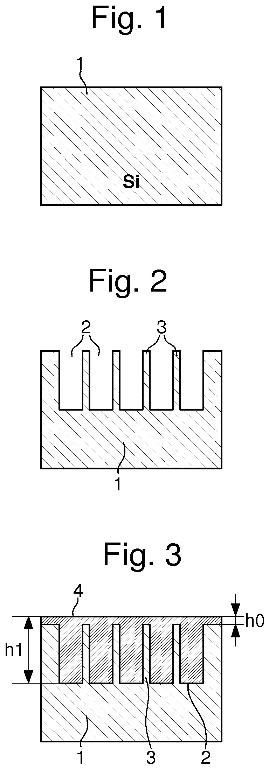

- les figures 1 à 3 illustrent schématiquement les étapes d'un procédé de fabrication selon l'invention.

### Description détaillée de l'invention

Le procédé de fabrication d'une pièce micromécanique horlogère à partir d'un substrat à base de silicium selon l'invention comprend tout d'abord une étape a) de formation de pores d'une profondeur déterminée, à partir de la surface d'au moins une partie d'une surface dudit substrat à base de silicium, lesdits pores débouchant à la surface externe du substrat à base de silicium. Le substrat à base de silicium est choisi en fonction de la pièce micromécanique horlogère à former. La forme finale du substrat à base de silicium en fonction de la pièce micromécanique horlogère à fabriquer est donnée avant ou après la mise en oeuvre du procédé de l'invention. Dans la présente invention, l'expression « substrat à base de silicium » désigne aussi bien une couche de silicium dans un substrat qu'un substrat en silicium. De préférence, comme représenté sur la figure 1, le substrat à base de silicium 1 est un wafer de silicium ou un wafer SOI (Silicon-on-Insulator). Les pores peuvent être formés aussi bien à la surface parallèle au plan du substrat qu'à la surface perpendiculaire au plan du substrat.

D'une manière avantageuse, cette étape a) peut être réalisée par un procédé choisi parmi le groupe comprenant un procédé par attaque électrochimique, un procédé de type « Stain-etch », et un procédé de type « MAC-Etch ».

Le procédé par attaque électrochimique peut être un procédé par anodisation électrochimique. Sa mise en oeuvre nécessite l'utilisation d'un bain électrochimique contenant de l'acide fluorhydrique en solution aqueuse ou mélangé à de l'éthanol dans des concentrations de 1 à 10%. Un courant électrique et des électrodes sont nécessaires pour créer des conditions électrochimiques induisant l'attaque du silicium. Selon les conditions électrochimiques, différents types de pores peuvent être obtenus. Un tel procédé est connu de l'homme du métier et ne nécessite pas d'informations détaillées ici.

Le procédé de type « Stain-etch » est basé sur une attaque humide du silicium aboutissant directement à la formation de silicium poreux. Typiquement, l'attaque se fait avec une solution HF/HNO₃/H₂O avec un rapport HF:HNO₃ de 50-500:1. Ce procédé présente l'avantage de ne pas nécessiter d'apport électrique dans le bain. Un tel procédé est connu de l'homme du métier et ne nécessite pas d'informations détaillées ici.

De préférence, l'étape a) est réalisée par un procédé de type « MAC-Etch ». Ce procédé est basé sur l'utilisation de particules de métaux nobles pour catalyser des réactions d'attaques chimiques locales. Typiquement, une couche très mince (10-50 nm) d'un métal noble (or, argent, platine) est déposée et structurée de manière aléatoire ou par lift-off, attaque, laser, etc. De préférence, le métal noble est de l'or. Plus particulièrement, on peut utiliser avantageusement des particules d'or en solution dans un mélange HF/H₂O₂. La taille des particules peut être comprise entre 5 et 1000 nm. La structuration peut être obtenue par lithographie de l'or, attaque ou lift-off. Une autre option est l'évaporation ou la pulvérisation cathodique (sputtering) d'une couche très fine non fermée (5-30 nm). Un traitement thermique pourra contribuer à la formation d'ilots d'or.

Lorsque le silicium avec la couche de métal noble est plongé dans une solution aqueuse d'un mélange HF/H₂O₂, le métal noble catalyse localement la dissolution du silicium. Cette solution d'attaque peut comprendre typiquement entre 4 ml : 1 ml : 8 ml (48% HF : 30% H₂O₂ : H₂O) et 4 ml : 1 ml : 40 ml (48% HF : 30% H₂O₂ : H₂O). La dissolution du silicium se produit préférentiellement sous le métal, celui-ci s'enfonçant alors progressivement dans le silicium. Cette réaction peut se poursuivre sur de grandes profondeurs (> 100 mµ) selon des modes de propagation essentiellement influencés par l'orientation du cristal de silicium, la disposition des surfaces, le dopage et la chimie du bain. Le procédé de type « MAC-Etch » présente l'avantage de ne pas nécessiter d'apport électrique dans le bain tout en autorisant la formation de pores de très grande profondeur (> 100 mµ) dans le silicium. Il est donc particulièrement adapté à l'utilisation, en tant que substrat, de wafers SOI généralement utilisés pour la fabrication des composants horlogers.

L'homme du métier connait les paramètres des procédés décrits ci-dessus à mettre en oeuvre pour que les pores formés dans le substrat à base de silicium présentent une géométrie et une taille appropriées.

Notamment, les pores peuvent présenter avantageusement un facteur d'aspect (rapport profondeur:diamètre) inférieur ou égal à 100:1. En particulier, lorsque l'étape b) est réalisée par un dépôt PVD, le facteur d'aspect des pores dans le substrat à base de silicium est de préférence inférieur ou égal à 4: 1. Lorsque l'étape b) est réalisée par un dépôt CVD ou MOCVD (metal organic chemical vapor deposition), le facteur d'aspect des pores dans le substrat à base de silicium est de préférence inférieur ou égal à 50:1.

De préférence, les pores peuvent présenter une profondeur supérieure à 100 µm, de préférence supérieure à 200 µm et plus préférentiellement supérieure à 300 µm.

Comme représenté sur la figure 2, la formation de pores 2 dans le substrat à base de silicium 1 sur une certaine profondeur entraine la formation, entre les pores 2, de piliers 3 à base de silicium sur la même profondeur. De préférence, en considérant les piliers à base de silicium comme ayant une section circulaire, les pores 2 sont formés de sorte que la surface projetée des piliers 3 à base de silicium est inférieure à 79% de la surface totale apparente afin de ne pas avoir de piliers à base de silicium qui se touchent, ce qui rigidifierait la structure (cela correspond au seuil de percolation).

La deuxième étape b) du procédé selon l'invention consiste à remplir entièrement les pores formés dans le substrat à base de silicium lors de l'étape a), d'un matériau choisi parmi le diamant, le carbone-diamant (DLC), l'oxyde de silicium, le nitrure de silicium, des céramiques, des polymères et leurs mélanges, afin de former dans les pores une couche dudit matériau d'une épaisseur au moins égale à la profondeur des pores.

Cette deuxième étape b) est effectuée directement après l'étape a), sans aucune étape intermédiaire, de sorte que le matériau déposé dans les pores est en contact direct avec les parois desdits pores.

De préférence, l'étape b) est réalisée par un procédé choisi parmi le groupe comprenant les procédés de dépôt de couche mince, tels que les procédés de dépôt chimique en phase vapeur (CVD), dépôt physique en phase vapeur (PVD), dépôt de couches minces atomiques (ALD), et l'oxydation thermique. Ces procédés sont connus de l'homme du métier et ne nécessitent pas d'informations détaillées ici. Il peut être précisé toutefois que pour un dépôt par PVD, le taux de dépôt sera de préférence compris entre 0.1 et 5 nm/s. Pour un dépôt par CVD ou MOCVD, le taux de dépôt sera de préférence compris entre 0.01 et 10 nm/s. Pour un dépôt par ALD, le taux de dépôt sera par exemple de 0.01 nm/s. Par ailleurs, l'oxydation thermique est particulièrement avantageuse pour réduire la proportion de silicium dans un substrat en silicium, le silicium se faisant consommer par la croissance à raison d'environ 50% de l'épaisseur de la couche. Ainsi, l'homme du métier sait dimensionner les pores devant être formés dans un substrat de silicium afin de permettre un remplacement à 100% du silicium par du SiO₂, aboutissant ainsi à la formation d'une couche de SiO₂ très épaisse en un temps très court.

Avantageusement, le procédé selon l'invention comprend après l'étape b), une étape c) de formation d'une couche de surface dudit matériau à la surface du substrat et des pores remplis du matériau. Plus particulièrement, cette couche de surface peut être obtenue en prolongeant le dépôt du matériau selon l'étape b) de manière à non seulement remplir entièrement les pores 2 du matériau mais également à ensuite déposer ledit matériau sur les pores 2 remplis du matériau ainsi que sur les piliers 3 pour former une couche pleine 4 dudit matériau d'épaisseur h0, comme le montre la figure 3. On obtient ainsi une couche composite d'épaisseur h1 comprenant les piliers 3, les pores 2 remplis de matériau et la couche pleine 4. Ainsi, on peut avoir par exemple un rapport h0/h1 de l'ordre de 10%.

Ainsi, le procédé selon l'invention permet d'obtenir une pièce micromécanique horlogère comprenant une couche composite épaisse à base de silicium/matériau déposé, voire une couche épaisse de matériau déposé lorsque tout le silicium a été remplacé.

La formation de pores à partir de la surface du substrat lors de l'étape a) permet de créer une très forte corrugation afin de créer une surface réelle bien supérieure à la surface initiale, sans pores. L'homme du métier sait choisir la géométrie des pores ainsi que le temps de dépôt du matériau dans les pores, afin de fabriquer, en surface du silicium, une couche épaisse en un temps fortement réduit par rapport à un dépôt sur une surface plane. Plus particulièrement, l'homme du métier sait choisir la géométrie et la taille des pores de manière à :
- obtenir un remplissage complet des pores lors du dépôt du matériau,
- faciliter l'écoulement des gaz
- obtenir le rapport de volume souhaité entre la couche de matériau déposé et les pores de silicium. Il est possible par exemple de fabriquer du silicium poreux avec une porosité de plus de 90% si nécessaire.
Par exemple, pour certains procédés de dépôt tels que CVD et PVD, le taux de dépôt a tendance à être plus lent au fond des pores. Il est alors possible de prévoir des pores coniques (plus large en surface qu'en profondeur) afin de compenser ce phénomène lié à l'écoulement des gaz.

Ainsi, avec un apport de gaz suffisant dans les pores, le procédé selon l'invention permet d'obtenir une couche composite silicium/matériau déposé d'épaisseur h1 dans un temps de dépôt proche de celui nécessaire à l'obtention d'une couche pleine du matériau d'épaisseur h0 correspondant à la couche de surface 4.

Le procédé selon l'invention peut avantageusement être mis en oeuvre pour la fabrication de composants de l'échappement à base de silicium, tels que la roue d'échappement et l'ancre, en formant des couches épaisses de diamant par CVD.

Le procédé selon l'invention peut également être mis en oeuvre pour la fabrication de composants de l'échappement à base de silicium, en formant des couches épaisses de Si02, quasiment massif si le procédé par oxydation thermique est utilisé pour le dépôt de Si02.

Le procédé selon l'invention peut également être mis en oeuvre pour créer rapidement des couches locales très épaisses en profondeur dans le silicium, en le combinant à la structuration de zones en silicium poreux.

## Revendications

1. Procédé de fabrication d'une pièce micromécanique horlogère à partir d'un substrat à base de silicium (1), comprenant, dans l'ordre, les étapes de :
a) former des pores (2) à la surface d'au moins une partie d'une surface dudit substrat à base de silicium (1) d'une profondeur déterminée,
b) remplir entièrement lesdits pores (2) d'un matériau choisi parmi le diamant, le carbone-diamant, à savoir du DLC, l'oxyde de silicium, le nitrure de silicium, des céramiques, des polymères et leurs mélanges, afin de former dans les pores (2) une couche dudit matériau d'une épaisseur au moins égale à la profondeur des pores (2).

2. Procédé selon la revendication 1, comprenant après l'étape b), une étape c) de formation d'une couche de surface (4) dudit matériau à la surface du substrat à base de silicium (1) et des pores (2) remplis du matériau.

3. Procédé selon l'une des revendications 1 à 2, dans lequel l'étape a) est réalisée par un procédé choisi parmi le groupe comprenant un procédé par attaque électrochimique, un procédé de type « Stain-etch », et un procédé de type « MAC-Etch ».

4. Procédé selon la revendication 3, dans lequel l'étape a) est réalisée par un procédé de type « MAC-Etch ».

5. Procédé selon l'une des revendications précédentes, dans lequel l'étape b) est réalisée par un procédé choisi parmi le groupe comprenant les procédés de dépôt de couche mince et l'oxydation thermique.

6. Procédé selon l'une des revendications précédentes, dans lequel les pores présentent un facteur d'aspect (rapport profondeur:diamètre) inférieur ou égal à 100:1.

7. Procédé selon l'une des revendications précédentes, dans lequel les pores (2) présentent une profondeur supérieure à 100 µm, de préférence supérieure à 200 µm et plus préférentiellement supérieure à 300 µm.

8. Procédé selon l'une des revendications précédentes, dans lequel le substrat à base de silicium (1) est un wafer de silicium ou un wafer SOI (Silicon-on-Insulator).

9. Pièce micromécanique horlogère susceptible d'être obtenue par le procédé selon l'une quelconque des revendications 1 à 8.

## Patentansprüche

1. Verfahren zum Herstellen eines mikromechanischen Uhrenteils ausgehend von einem Substrat (1) auf Siliziumbasis, das in dieser Reihenfolge die Schritte umfasst:
a) Bilden von Poren (2) in der Oberfläche zumindest eines Teils einer Oberfläche des Substrats (1) auf Siliziumbasis mit einer bestimmten Tiefe,
b) vollständiges Füllen der Poren (2) mit einem Material, das aus Diamant, Kohlenstoff-Diamant, nämlich DLC, Siliziumoxid, Siliziumnitrid, Keramiken, Polymeren und ihren Gemischen gewählt ist, um in den Poren (2) eine Schicht aus dem Material mit einer Dicke zu bilden, die mindestens gleich der Tiefe der Poren (2) ist.

2. Verfahren nach Anspruch 1, umfassend nach dem Schritt b) einen Schritt c) des Bildens einer Oberflächenschicht (4) aus dem Material auf der Oberfläche des Substrats (1) auf Siliziumbasis und den Poren (2), die mit dem Material gefüllt sind.

3. Verfahren einem der Ansprüche 1 bis 2, wobei der Schritt a) durch ein Verfahren ausgeführt wird, das aus der Gruppe gewählt ist, die ein Verfahren mit elektrochemischer Ätzung, ein Verfahren des Typs "Stain-Etch" und ein Verfahren des Typs "MAC-Etch" umfasst.

4. Verfahren nach Anspruch 3, wobei der Schritt a) durch ein Verfahren des Typs "MAC-Etch" ausgeführt wird.

5. Verfahren nach einem der vorhergehenden Ansprüche, wobei der Schritt b) durch ein Verfahren ausgeführt wird, das aus der Gruppe gewählt ist, die die Verfahren der Dünnschichtablagerung und der thermischen Oxidation umfasst.

6. Verfahren einem der vorhergehenden Ansprüche, wobei die Poren einen Formfaktor (Verhältnis von Tiefe zu Durchmesser) kleiner oder gleich 100:1 aufweisen.

7. Verfahren nach einem der vorhergehenden Ansprüche, wobei die Poren (2) eine Tiefe von mehr als 100 µm, vorzugsweise mehr als 200 µm und besonders bevorzugt mehr als 300 µm aufweisen.

8. Verfahren nach einem der vorhergehenden Ansprüche, wobei das Substrat (1) auf Siliziumbasis ein Silizium-Wafer oder ein SOI (Silicon-on-Insulator)-Wafer ist.

9. Mikromechanisches Uhrenteil, das durch das Verfahren nach einem der Ansprüche 1 bis 8 erhaltbar ist.

## Claims

1. Method for manufacturing a micromechanical timepiece part starting from a silicon-based substrate (1), comprising, in order, the steps of:
a) forming pores (2) on the surface of at least one part of a surface of said silicon-based substrate (1) of a determined depth,
b) entirely filling said pores (2) with a material chosen from diamond, diamond-like carbon (that means DLC), silicon oxide, silicon nitride, ceramics, polymers and mixtures thereof, in order to form, in the pores (2), a layer of said material of a thickness at least equal to the depth of the pores (2).

2. Method according to claim 1, comprising, after step b), a step c) of forming a surface layer (4) of said material on the surface of the silicon-based substrate (1) and of the pores (2) filled with the material.

3. Method according to one of the claims 1 to 2, in which step a) is achieved by a method chosen from the group comprising a method by electrochemical etching, a method of the « Stain-etch » type and a method of the « MAC-Etch » type.

4. Method according to claim 3, in which step a) is achieved by a method of the « MAC-Etch » type.

5. Method according to one of the preceding claims, in which step b) is achieved by a method chosen from the group comprising methods of thin-film deposition and thermal oxidation.

6. Method according to one of the preceding claims, in which the pores have an aspect factor (depth : diameter ratio) less than or equal to 100 : 1.

7. Method according to one of the preceding claims, in which the pores (2) have a depth greater than 100 µm, preferably greater than 200 µm and more preferably greater than 300 µm.

8. Method according to one of the preceding claims, in which the silicon-based substrate (1) is a silicon wafer or an SOI wafer (Silicon-on-Insulator).

9. Mechanical timepiece part obtainable by the method according to any of the claims 1 to 8.
